# EUROPEAN PATENT APPLICATION

(11) **EP 4 175 431 A1**
(43) Date of publication of application: **03.05.2023**
(21) Application number: 21833210.4
(22) Date of filing: 04.06.2021
(51) Int. Cl.: H05K 7/20

(54) **TEMPERATURE REGULATING STRUCTURE FOR ELECTRONIC EQUIPMENT**

(30) Priority: 30.06.2020 JP 2020113447
(71) Applicant: YOKOWO CO., LTD., Kita-ku Tokyo 114-8515 (JP)
(72) Inventor: AMBE, Tomio, Tomioka-Shi Gunma 370-2495 (JP); HIROSAWA, Takeshi, Tomioka-Shi Gunma 370-2495 (JP)
(74) Representative: Gunzelmann, Rainer
(86) International application number: PCT/JP2021/021326
(87) International publication number: WO 2022/004272

(57) **Abstract**

Provided is a temperature adjusting structure for an electronic equipment provided inside a vehicle or the like. The temperature adjusting structure for an electronic equipment provided inside the vehicle includes a first region 50. The first region 50 is connected, through an air supply port 51a, to at least one of a different region from the first region 50 that is to have cooler air or warmer air than the first region 50, and a duct 1c of an air conditioner 1d of a vehicle 1. Air which is to flow into the air supply port 51a is to flow into a region where the electronic equipment 10 is present in the first region 50.

## Description

### TECHNICAL FIELD

The present invention relates to a temperature adjusting structure for an electronic equipment, or the like.

### BACKGROUND ART

In the related art, an electronic equipment provided inside a vehicle, such as a transmission and reception unit disclosed in Patent Literature 1, has been proposed.

### CITATION LIST

### PATENT LITERATURE

Patent Literature 1: JP2019-47192A

### SUMMARY OF INVENTION

### TECHNICAL PROBLEM

However, a temperature of an electronic equipment provided inside a vehicle may become too high or too low, for which temperature adjustment may be required.

Therefore, an object of the present invention is to provide a temperature adjusting structure for an electronic equipment provided inside a vehicle, or the like.

### SOLUTION TO PROBLEM

A temperature adjusting structure for an electronic equipment provided inside a vehicle according to the present invention includes a first region. The first region is connected, through an air supply port, to at least one of a different region from the first region that is to have cooler air or warmer air than the first region, and a duct of an air conditioner of the vehicle. Air which is to flow into the air supply port is to flow into a region where the electronic equipment is present in the first region.

### ADVANTAGEOUS EFFECTS OF INVENTION

As described above, according to the present invention, it is possible to provide a temperature adjusting structure for an electronic equipment provided inside a vehicle, or the like.

### BRIEF DESCRIPTION OF DRAWINGS

[FIG. 1] FIG. 1 is a perspective view of a vehicle including a first region according to a first embodiment.
[FIG. 2] FIG. 2 is a configuration diagram of xz cross section of a region where an electronic equipment is present in the first region according to the first embodiment.
[FIG. 3] FIG. 3 is a configuration diagram of xz cross section of a substrate, a mounted component, a thermal interface material, a shielding plate, and a heat absorbing and releasing member in a case where the shielding plate and the heat absorbing and releasing member according to the first embodiment are configured separately.
[FIG. 4] FIG. 4 is a configuration diagram of xz cross section of the substrate, the mounted component, the thermal interface material, the shielding plate, and the heat absorbing and releasing member in a case where the shielding plate and the heat absorbing and releasing member according to the first embodiment are configured integrally.
[FIG. 5] FIG. 5 is an enlarged perspective view of a region where the first region in FIG. 1 is present.
[FIG. 6] FIG. 6 is a schematic diagram illustrating a comparison of cross-sectional areas of a front-stage region, a central region, a rear-stage region, an air supply opening, and an air discharge opening according to the first embodiment.
[FIG. 7] FIG. 7 is a cross-sectional configuration diagram of a space including a driver seat of the vehicle including an air supply port that takes in air from a second region according to the first embodiment, as viewed from an inner side.
[FIG. 8] FIG. 8 is a perspective view of a vehicle including a first region according to a second embodiment.
[FIG. 9] FIG. 9 is a schematic diagram illustrating a comparison of cross-sectional areas of a front-stage region, a central region, and a rear-stage region according to a third embodiment.
[FIG. 10] FIG. 10 is a perspective view of an electronic equipment according to the third embodiment.
[FIG. 11] FIG. 11 is a configuration diagram of xz cross section of a region where an electronic equipment is present in a first region according to the third embodiment.
[FIG. 12] FIG. 12 is a perspective view of an electronic equipment according to a fourth embodiment.
[FIG. 13] FIG. 13 is a configuration diagram of yz cross section of the electronic equipment according to the fourth embodiment.
[FIG. 14] FIG. 14 is a perspective view of an electronic equipment, a portion adjacent to a central region of a front-stage region, a central region, and a portion adjacent to a central region of a rear-stage region according to a fifth embodiment, in which an upper surface of the central region is omitted.
[FIG. 15] FIG. 15 is a perspective view of an electronic equipment, a portion adjacent to a central region of a front-stage region, a central region, and a portion adjacent to a central region of a rear-stage region according to a sixth embodiment, in which an upper surface of the central region is omitted.
[FIG. 16] FIG. 16 is a perspective view of an electronic equipment, a portion adjacent to a central region of a front-stage region, a central region, and a portion adjacent to a central region of a rear-stage region according to a seventh embodiment, in which an upper surface of the central region is omitted.
[FIG. 17] FIG. 17 is a cross-sectional configuration diagram of a space including a driver seat of a vehicle according to an eighth embodiment as viewed from the inner side, and includes a first region extending in a front-rear direction.
[FIG. 18] FIG. 18 is a perspective view of a vehicle including a first region according to a ninth embodiment.
[FIG. 19] FIG. 19 is a perspective view of an electronic equipment according to a tenth embodiment.

### DESCRIPTION OF EMBODIMENTS

Hereinafter, a first embodiment and the like will be described with reference to the drawings.

The embodiments are not limited to the following embodiments. In principle, contents described in one embodiment are similarly applied to other embodiments. The embodiments and modifications may be combined as appropriate.

### (Configuration of Vehicle 1)

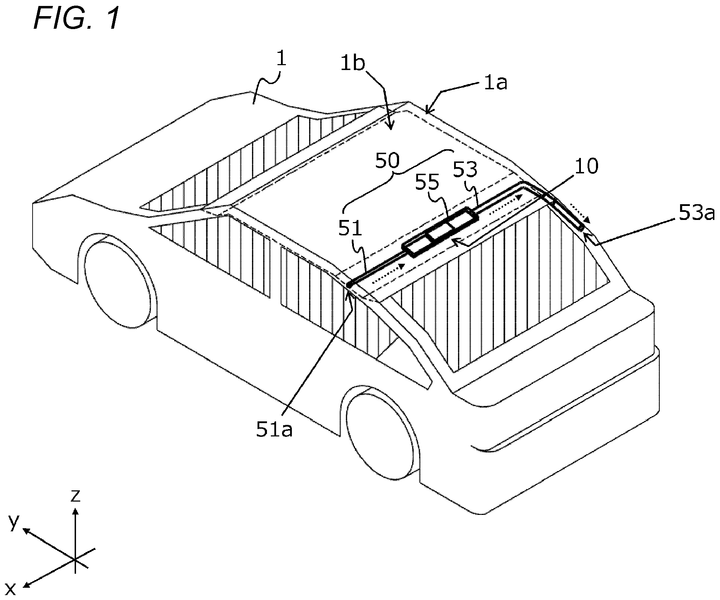

As illustrated in FIGS. 1 to 7, a vehicle 1 according to the first embodiment includes an electronic equipment (antenna device) 10 and a first region (cooling air introduction region) 50.

In order to explain directions, a left-right direction of the vehicle 1 in which the first region 50 is provided is referred to as an x direction, a front-rear direction perpendicular to the x direction is referred to as a y direction, and a substantially vertical direction perpendicular to the x direction and the y direction is referred to as a z direction. In FIG. 1, etc., directions indicated by respective arrows of the xyz axes are defined as a left direction, a front direction, and an upper direction, respectively.

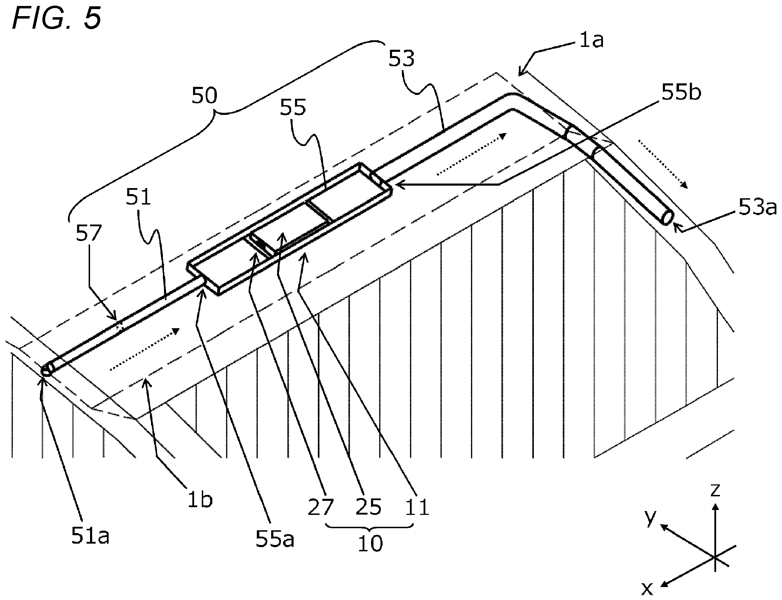

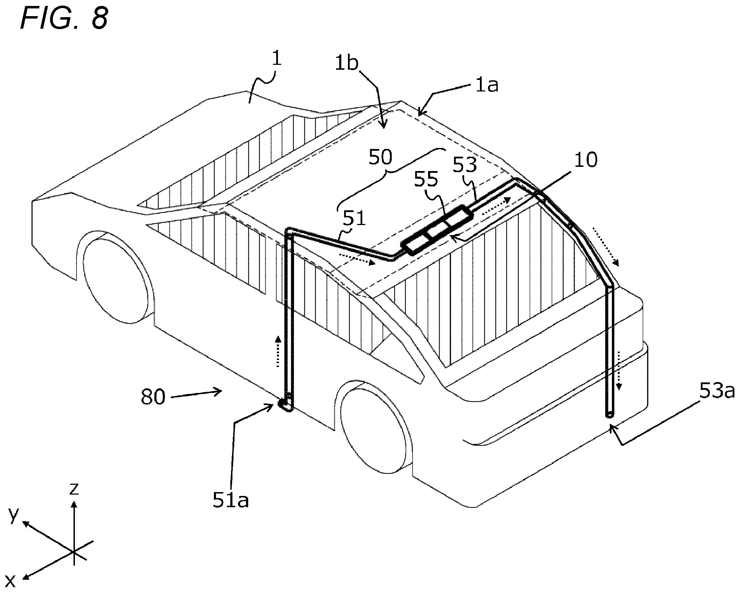

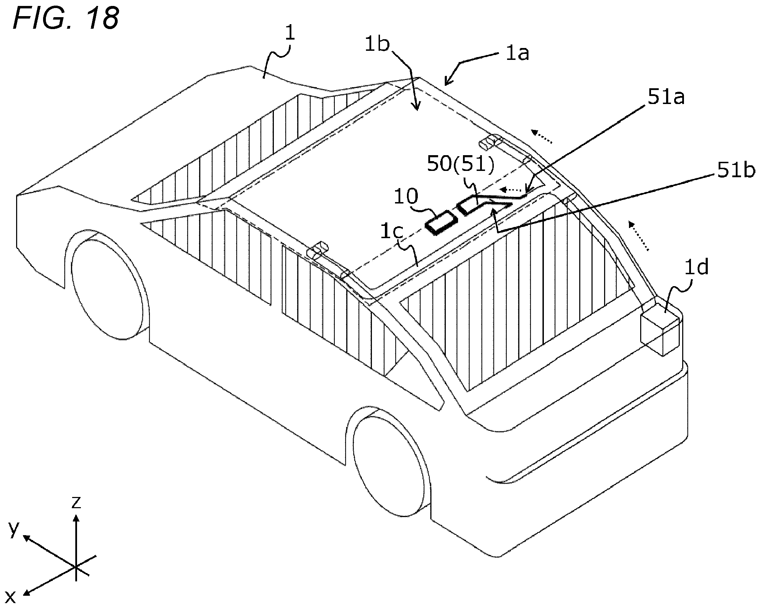

In perspective views in FIGS. 1 and 5, the first region 50 is not actually seen from an outer side, but in order to explain the invention, a state is illustrated where a content (first region 50) is seen through and an upper surface of a central region 55 is omitted such that an electronic equipment 10 provided inside the central region 55 is seen. The same applies to FIG. 8 of a second embodiment and FIG. 18 of a ninth embodiment.

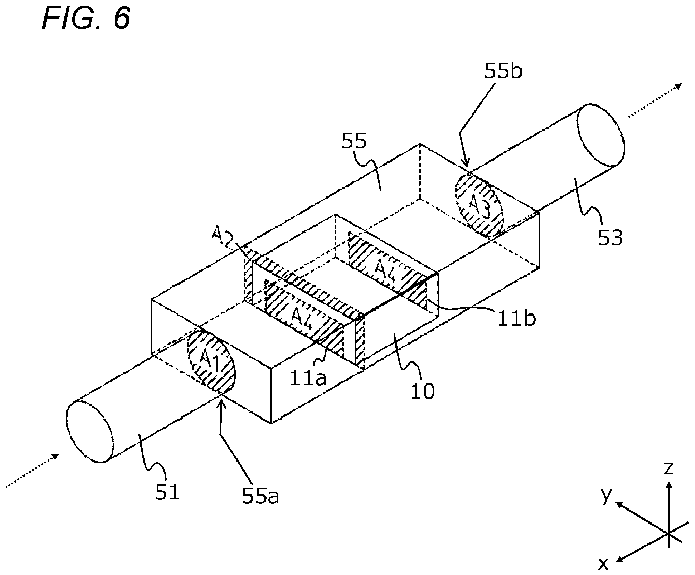

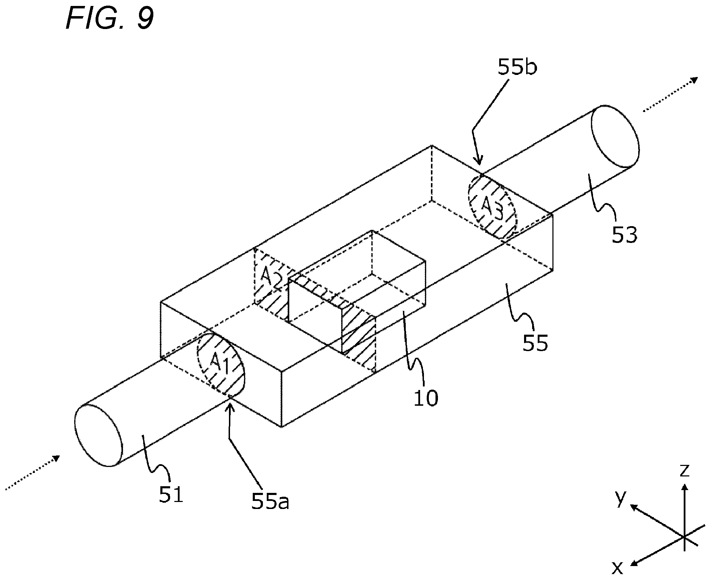

In addition, in a perspective view in FIG. 6, the electronic equipment 10 is not actually seen from the outer side, but in order to explain the invention, a state where a content (electronic equipment 10) is seen through is illustrated. The same applies to FIG. 9 of a third embodiment.

In addition, in FIG. 1, etc., a direction of a flow of air is indicated by dotted arrows.

### (Electronic Equipment 10)

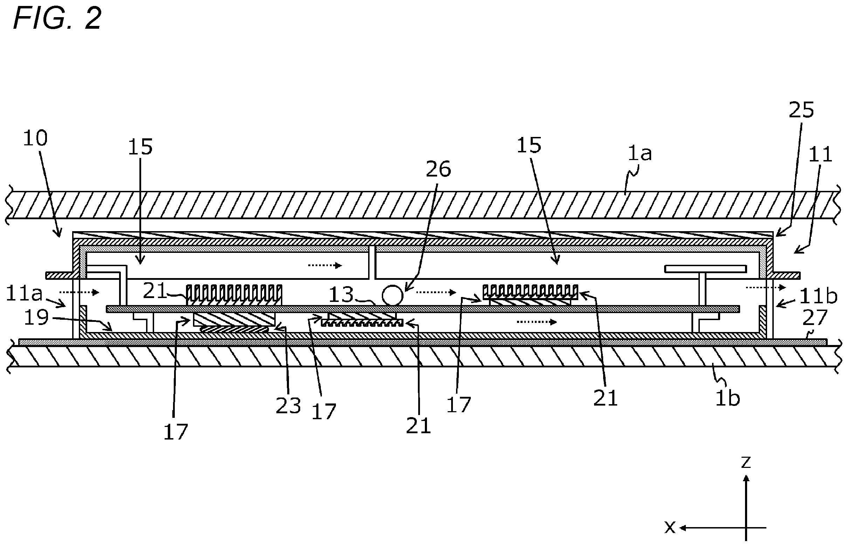

The electronic equipment 10 is an antenna device or the like. According to the first embodiment, the electronic equipment 10 is described as an antenna device, but may be another device. As illustrated in FIG. 2, the electronic equipment 10 as an antenna device includes an antenna case (housing) 11, a substrate 13, antenna elements 15, mounted components 17, a ground plate 19, heat absorbing and releasing members 21, a thermal interface material 23, a heat insulating material 25, a heat storage material 26, and a bracket 27.

### (Antenna Case 11)

The antenna case 11 constitutes a side surface and an upper surface of the electronic equipment 10. The antenna case 11 is made of synthetic resin having radio wave transparency. The antenna case 11 covers members constituting the electronic equipment 10, such as the substrate 13, from above in the z direction. It is desirable that the antenna case 11 be made of a resin having high thermal conductivity.

An air supply opening 11a is provided in a front surface of the antenna case 11. The front surface of the antenna case 11 is one of side surfaces constituting the antenna case 11 that faces a front-stage region 51 when the electronic equipment 10 is accommodated in the central region 55 of the first region 50 to be described later. An air discharge opening 1 1b is provided on a back surface of the antenna case 11. The back surface of the antenna case 11 is one of the side surfaces constituting the antenna case 11 that faces a rear-stage region 53 when the electronic equipment 10 is accommodated in the central region 55.

### (Substrate 13)

The antenna elements 15, the mounted components 17, and the like are attached to the substrate 13. The substrate 13 is held by the ground plate 19.

### (Antenna Element 15)

The antenna element 15 transmits and receives electrical signals. For example, the antenna element 15 may be a planar antenna for receiving satellite broadcasting, a planar antenna for receiving position information (time information) from a satellite such as a GPS, an antenna including a capacitance loaded element and a coil for receiving AM/FM broadcasting, an antenna for V2X (vehicle-to-vehicle and road-to-vehicle communication), an antenna for a communication terminal, or the like. The antenna element 15 is held by the substrate 13. However, the antenna element 15 may be held by the ground plate 19 or may be held by the antenna case 11. A part of the antenna element 15 may be in contact with an inner wall of the antenna case 11. It is desirable that the antenna element 15 be made of a metal having a high thermal conductivity, such as a copper alloy or an aluminum alloy.

According to the first embodiment, an example in which the antenna element 15 is provided in the inner side of the antenna case 11 will be described. However, a part or all of the antenna element 15 may be provided in the outer side of the antenna case 11.

### (Mounted Component 17)

The mounted component 17 includes a semiconductor, and is a circuit that performs signal processing on an electrical signal transmitted and received by the antenna element 15, such as an amplifier circuit and a tuning circuit. The mounted component 17 is attached to a front surface (upper surface) or a back surface (lower surface) of the substrate 13.

### (Ground Plate 19)

The ground plate 19 is, for example, a metal plate functioning as an antenna base. The substrate 13 and the mounted component 17 are connected to the ground plate 19 through the thermal interface material 23. The ground plate 19 is disposed at a lower portion of the substrate 13 so as to be separated from the substrate 13.

### (Heat Absorbing and Releasing Member 21)

The heat absorbing and releasing member 21 is configured by a heat sink including a fin for heat releasing or the like, and is attached to a region where heat is generated in the substrate 13 and a region where heat is generated in the mounted component 17 and the like. The heat absorbing and releasing member 21 is used to radiate heat of the members constituting the electronic equipment 10, particularly, heat of the region where heat is generated in the substrate 13 and the region where heat is generated in the mounted component 17 and the like. In order not to affect transmission and reception performance of the antenna, it is desirable that the heat absorbing and releasing member 21 be provided on the lower surface rather than on the upper surface of the substrate 13. A dimension and a shape of each heat absorbing and releasing member 21 are determined such that a surface area of a portion of a corresponding heat absorbing and releasing member 21 to be exposed to an outside air is larger than an area of a portion of the substrate 13 or the mounted component 17 to which the heat absorbing and releasing member 21 is directly or indirectly attached. The heat absorbing and releasing member 21 is not limited to a member having an uneven shape such as a fin, and may be a plate-like member. The heat absorbing and releasing member 21 is not limited to metal, and may be made of a resin or the like.

### (Thermal Interface Material 23)

The thermal interface material (TIM) 23 includes a silicon sheet, a thermal grease thermally conductive sheet, a phase change material (PCM), a gel (thermal conductive gap filler), a high thermal conductive adhesive, a thermal tape (thermal conductive double-sided tape), and the like. The thermal interface material 23 is provided between the substrate 13 and the ground plate 19, between the mounted component 17 and the ground plate 19, or the like. The thermal interface material 23 accumulates heat of contacting members (the substrate 13, the mounted component 17, and the like) and transfers the heat to other members such as the ground plate 19. The thermal interface material 23 is used for heat exchange between the ground plate 19 and heat generating portions of the substrate 13 and the mounted component 17. The thermal interface material 23 may also be provided between the substrate 13 and the heat absorbing and releasing member 21 and between the mounted component 17 and the heat absorbing and releasing member 21.

### (Shielding Plate 24)

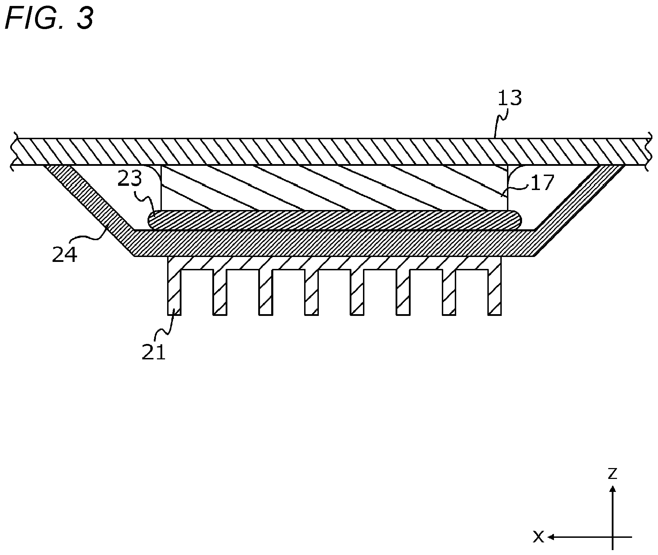

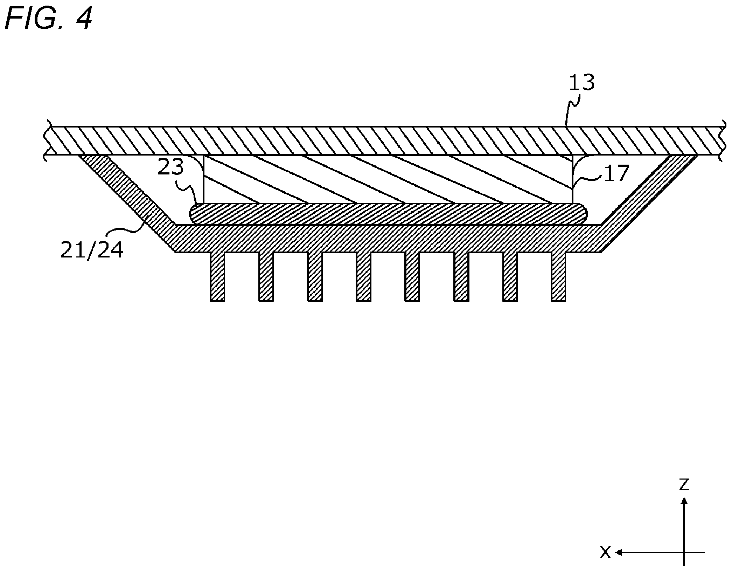

A shielding plate 24 for suppressing noise generated by the mounted component 17 from affecting other components such as the antenna element 15 may be provided in a periphery of the mounted component 17 (see FIG. 3). In this case, the thermal interface material 23 is provided between the mounted component 17 and the shielding plate 24. When the heat absorbing and releasing member 21 is attached to the shielding plate 24, the shielding plate 24 and the heat absorbing and releasing member 21 may be configured separately, but as illustrated in FIG. 4, the shielding plate 24 and the heat absorbing and releasing member 21 may be configured integrally. In this case, configurations of the heat absorbing and releasing member 21 and the shielding plate 24 can be simplified, and heat transfer efficiency can be increased.

### (Heat Insulating Material 25)

The heat insulating material 25 is provided on the upper surface of the antenna case 11. The heat insulating material 25 is provided to make it difficult for heat from the outside, such as sunlight, to be transferred to an inside of the electronic equipment 10.

### (Heat Storage Material 26)

The heat storage material 26 is made of a phase change heat storage material such as paraffin, and is used to reduce a temperature increase of the inside of the electronic equipment 10. The heat storage material 26 is disposed on the substrate 13 or the like in a state of being placed in a sealed container such as a capsule.

### (Bracket 27)

The bracket 27 is formed of a metal member and is disposed on the central region 55 of the first region 50. The electronic equipment 10 is attached to the bracket 27 such that a lower surface of the ground plate 19 is in contact with an upper surface of the bracket 27. According to the first embodiment, an example in which the bracket 27 is attached to a lower surface of the first region 50 is illustrated, but the bracket 27 may be suspended from another surface (for example, an upper surface).

### (First Region 50)

As illustrated in FIG. 5, the first region 50 is provided inside the vehicle 1 and accommodates the electronic equipment 10 therein. The first region 50 takes in air from a region (a second region 70 or the like) different from the first region 50, and cools the electronic equipment 10 using the taken in air. That is, the first region 50 constitutes a temperature adjusting structure for the electronic equipment 10.

The electronic equipment 10 and a region (central region 55) of the first region 50 in which the electronic equipment 10 is accommodated are provided in a region between a roof 1a and a roof lining 1b of the vehicle 1. However, the electronic equipment 10 and the central region 55 are not limited to a mode of being provided between the roof 1a and the roof lining 1b. For example, the electronic equipment 10 and the central region 55 may be provided in another region different from the second region 70 of the vehicle 1.

The first region 50 includes the front-stage region 51, the rear-stage region 53, the central region 55, and a fan 57. The central region 55 is provided between the front-stage region 51 and the rear-stage region 53. The front-stage region 51, the central region 55, and the rear-stage region 53 are arranged in the x direction.

### (Front-stage Region 51)

The front-stage region 51 is formed of a tubular member. One end portion of the front-stage region 51 is opened as an air supply port 51a. The front-stage region 51 is connected to the second region 70 to be described later through the air supply port 51a. The front-stage region 51 is connected, through the other end portion of the front-stage region 51, to a first end region 55a including one end portion of the central region 55, that is, a region in contact with the other end portion of the front-stage region 51.

### (Rear-stage Region 53)

The rear-stage region 53 is formed of a tubular member. One end portion of the rear-stage region 53 is connected to a second end region 55b including the other end portion of the central region 55, that is, a region in contact with the one end portion of the rear-stage region 53. The other end portion of the rear-stage region 53 is opened as an air discharge port 53a. The rear-stage region 53 is connected, through the air discharge port 53a, to a region different from a space including the driver seat, a passenger seat, and rear seats, such as a trunk room (hereinafter, referred to as a "space including the driver seat").

### (Central Region 55)

The central region 55 is a region where the electronic equipment 10 is accommodated. A yz cross section of the central region 55 is larger than yz cross sections of the front-stage region 51 and the rear-stage region 53. A hole (not illustrated) through which a cable or a connector for electrical connection between the electronic equipment 10 and other devices inside the vehicle 1 passes is provided on a bottom surface, a side surface, or the like of the central region 55.

### (Fan 57)

The fan 57 takes in air in the second region 70 from the air supply port 51a and discharges air in the first region 50 from the air discharge port 53a. The fan 57 is provided in at least one of the front-stage region 51, the central region 55, and the rear-stage region 53. For example, one fan 57 is provided in the front-stage region 51 for air supply, and one fan 57 is provided in the rear-stage region 53 for air discharge. However, one fan 57 may be provided for both air supply and air discharge in the front-stage region 51 or the rear-stage region 53. According to the first embodiment, an example is illustrated in which one fan 57 is provided in the front-stage region 51 (see FIG. 5).

The fan 57 is turned on for a first time T1 (for example, T1 = 5 minutes) after an accessory switch of the vehicle 1 is turned on. However, an on-off control of the fan 57 is not limited thereto. For example, the on-off control of the fan 57 may be performed based on at least one of a temperature state and a humidity state of the electronic equipment 10. Specifically, at least one of temperature information and humidity information of the electronic equipment 10 is detected, and the fan 57 is turned on when at least one of a condition that a temperature T of the electronic equipment 10 exceeds a temperature threshold Tth (for example, Tth = 60°C) and a condition that a humidity H of the electronic equipment 10 exceeds a humidity threshold Hth (for example, Hth = 50%) is satisfied. The on-off control of the fan 57 is performed by an electronic control unit (ECU, not illustrated) or the like of the vehicle 1.

### (Cross-sectional Area of Each Cross Section)

In order to facilitate a flow of air from the front-stage region 51 to the rear-stage region 53 through the central region 55, dimensions of respective portions are determined such that cross-sectional areas of yz cross sections (flow path cross sections) of the respective portions of the first region 50 satisfy the following relationships (see FIG. 6). A cross-sectional area A1 of the yz cross section of the front-stage region 51 is smaller than an opening area A4 of the air supply opening 11a and an opening area A4 of the air discharge opening 11b (A1 < A4). A difference A2 between a cross-sectional area of the yz cross section of the central region 55 and a cross-sectional area of the yz cross section of the electronic equipment 10 is smaller than the opening area A4 of the air supply opening 11a and the opening area A4 of the air discharge opening 11b (A2 < A4). The cross-sectional area A1 of the yz cross section of the front-stage region 51 is equal to a cross-sectional area A3 of the yz cross section of the rear-stage region 53 or smaller than the cross-sectional area A3 (A1 ≤ A3). By making the opening area A4 larger than the difference A2, it is possible to suppress the air from the front-stage region 51 from flowing to the rear-stage region 53 through an outer periphery of the electronic equipment 10, and to cause the air to flow into the electronic equipment 10 from the intake opening 11a and then to flow to the rear-stage region 53.

The intake opening 11a and the air discharge opening 11b illustrated in FIG. 6 are different in shape from the intake opening 11a and the air discharge opening 11b illustrated in FIG. 2. However, FIG. 6 schematically illustrates size relationships between the opening areas A4 of the intake opening 11a and the air discharge opening 11b, the cross-sectional area A1 of the front-stage region 51, the cross-sectional area A3 of the rear-stage region 53, and the difference A2 in cross-sectional area. That is, shapes of the intake opening 11a and the air discharge opening 11b including shapes of the intake opening 11a and the air discharge opening 11b illustrated in FIG. 2 may be any shapes as long as the above-mentioned size relationships are satisfied.

### (Second Region 70)

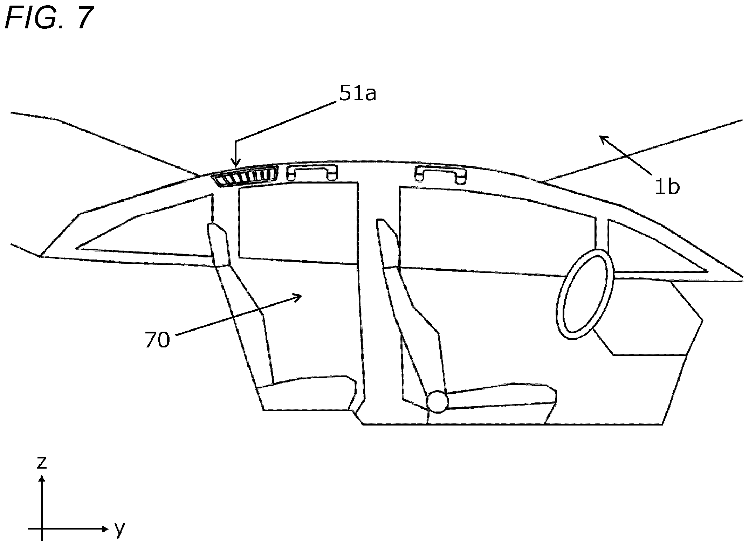

The second region 70 is a region different from the first region 50 of the vehicle 1, and is, for example, a region below the roof lining 1b of the vehicle 1, that is, a space including the driver seat. That is, according to the first embodiment, the second region 70 corresponds to a region that is different from the first region 50 and has cooler air than the first region 50. In this case, the air supply port 51a is provided near the roof lining 1b above a side portion of the space including the driver seat (see FIG. 7).

### (Cooling Procedure of Electronic Equipment 10)

Next, a cooling procedure of the electronic equipment 10 will be described. In advance, the electronic equipment 10 is installed in the first region 50, and the first region 50 is installed in the vehicle 1. When the accessory switch of the vehicle 1 is turned on, for example, when an engine of the vehicle 1 is turned on, the fan 57 operates for the first time T1. The electronic equipment 10 may be turned on while the accessory switch of the vehicle 1 is turned on, or a part or all of the electronic equipment 10 may be turned on regardless of whether the accessory switch is turned on.

When the fan 57 operates, the air in the second region 70 flows into the front-stage region 51 of the first region 50 through the air supply port 51a. The air flowing into the front-stage region 51 flows into the central region 55. The air flowing into the central region 55 flows into the inside of the electronic equipment 10 through the air supply opening 11a. The air flowing into the inside of the electronic equipment 10 exchanges heat with the members in the inside of the electronic equipment 10 such as the substrate 13, cools the members, and is discharged from the air discharge opening 11b. The air after the heat exchange discharged from the air discharge opening 11b passes through the rear-stage region 53. The air is discharged, through the air discharge port 53a, to a third region 80 to be described later, or a region different from the space including the driver seat inside the vehicle 1, such as a trunk room.

### (Effect of Providing Temperature Adjusting Structure)

The air is taken from the second region 70 or the like into the front-stage region 51 of the first region 50 through the air supply port 51a, and the taken in air is used for temperature adjustment of the electronic equipment 10. Accordingly, the temperature adjustment of the electronic equipment 10 is facilitated than in a mode in which the temperature adjustment is not performed using air from an outside different from the region where the electronic equipment 10 is disposed. In addition, by continuously feeding air to the region where the electronic equipment 10 is present, the air continues to flow to the electronic equipment 10. Therefore, it is easy to maintain a dried state of the members of the electronic equipment 10.

The "temperature adjustment" in the present embodiment means adjusting the temperature such that the temperature does not affect the performance of the electronic equipment 10. For example, when it is experimentally understood that the performance of the electronic equipment 10 is affected when the temperature becomes equal to or higher than a predetermined temperature or equal to or lower than the predetermined temperature in a certain environment, the "temperature adjustment" in the present embodiment means that the temperature is adjusted such that the temperature does not become equal to or higher than the predetermined temperature or equal to or lower than the predetermined temperature.

### (Effect of Providing Fan 57 Separate from Electronic Equipment 10)

By using the fan 57, it is possible to cause air to flow into the region where the electronic equipment 10 is present or to discharge the air after the heat exchange from the region where the electronic equipment 10 is present, regardless of a pressure state of the first region 50.

### (Effect of Operating Fan 57 When Accessory Switch is Turned On)

Immediately before the accessory switch of the vehicle 1 is turned on, there is a possibility that the temperature of the electronic equipment 10 is high, such as the vehicle 1 is not running. Therefore, if the fan 57 is operated when the accessory switch of the vehicle 1 is turned on, the temperature adjustment of the electronic equipment 10 can be more effectively performed than in a mode in which the fan 57 is operated in another time zone.

### (Effect of Providing Air Hole in Housing of Electronic Equipment 10)

By providing air holes (the air supply opening 11a and the air discharge opening 11b) in the housing of the electronic equipment 10, the air from the front-stage region 51 can be taken into the inside of the electronic equipment 10. Therefore, the temperature adjustment of the members in the inside of the electronic equipment 10 is facilitated than in a mode in which the temperature is adjusted by applying the air from the front-stage region 51 to an outside of the electronic equipment 10.

### (Effect of Introducing Air from Space Including Driver Seat)

The second region 70 is located at a position lower than the first region 50, and may be in a temperature state different from that of the first region 50. For example, in a hot weather of which the temperature is high, there is a high possibility that a space including a cab (second region 70) is in a lower temperature state than that directly below the roof 1a (first region 50). Therefore, the temperature adjustment of the electronic equipment 10 can be performed by the air flowing in from the second region 70.

### (Application Example of Air Inlet Portion)

According to the first embodiment, an example has been described in which air is caused to flow from the space including the driver seat (second region 70) inside the vehicle 1 to the region where the electronic equipment 10 is present through the front-stage region 51. However, the second region 70 is not limited to the space including the driver seat, and may be a space different from the first region 50 and the space including the driver seat in the vehicle 1, such as a trunk room.

In addition, an example has been described in which a region that is different from the first region 50 and has cooler air than the first region 50 is a region (second region 70) inside the vehicle 1, such as the space including the driver seat, and the front-stage region 51 of the first region 50 is connected to the second region 70. However, the region that is different from the first region 50 and has the cooler air than the first region 50 may be a region outside the vehicle 1. That is, the front-stage region 51 of the first region 50 may be connected, through the air supply port 51a, to the third region 80 located outside the vehicle 1 and at a position lower than the first region 50 (see FIG. 8, the second embodiment). In this case, the front-stage region 51 extends to an underfloor of the vehicle 1 through a center pillar or the like of the vehicle 1. The rear-stage region 53 extends to the underfloor of the vehicle 1 through a rear pillar or the like of the vehicle 1. The rear-stage region 53 of the first region 50 is connected to the third region 80 through the air discharge port 53a.

According to the second embodiment, when the fan 57 operates, the air in the third region 80 flows into the front-stage region 51 of the first region 50 through the air supply port 51a. The air flowing into the front-stage region 51 flows into the central region 55. The air flowing into the central region 55 flows into the inside of the electronic equipment 10 through the air supply opening 11a. The air flowing into the inside of the electronic equipment 10 exchanges heat with the members in the inside of the electronic equipment 10 such as the substrate 13, cools the members, and is discharged from the air discharge opening 11b. The air after the heat exchange discharged from the air discharge opening 11b passes through the rear-stage region 53. The air is discharged, through the air discharge port 53a, to the third region 80, or the region different from the space including the driver seat inside the vehicle 1, such as a trunk room.

### (Effect of Introducing Air from Underfloor)

The third region 80 is located at a position lower than the first region 50, and may be in a temperature state different from that of the first region 50. For example, in a hot weather of which the temperature is high, there is a high possibility that the underfloor of the vehicle (third region 80) is in a lower temperature state than that directly below the roof 1a (first region 50). Therefore, the temperature adjustment of the electronic equipment 10 can be performed by the air flowing in from the third region 80.

### (Temperature Adjustment from Above Electronic Equipment 10 or the like)

According to the first embodiment, an example has been described in which the air taken in from the outside through the front-stage region 51 passes through the inside of the electronic equipment 10 and cools the electronic equipment 10. However, the air taken in from the outside through the front-stage region 51 may pass through the outside of the electronic equipment 10 and cool the electronic equipment 10 (see FIGS. 9 to 11, the third embodiment).

The antenna case 11 of the electronic equipment 10 according to the third embodiment does not include the air supply opening 11a and the air discharge opening 11b. In addition, on the upper surface of the antenna case 11 of the electronic equipment 10 according to the third embodiment, a heat releasing fin 29 is provided instead of the heat insulating material 25.

### (Cross-sectional Area of Each Cross Section)

In order to facilitate a flow of air from the front-stage region 51 to the rear-stage region 53 through the central region 55, the dimensions of the respective portions are determined such that the cross-sectional areas of the yz cross sections (flow path cross sections) of the respective portions of the first region 50 satisfy the following relationships (see FIG. 9). The cross-sectional area A1 of the yz cross section of the front-stage region 51 is smaller than the difference A2 between the cross-sectional area of the yz cross section of the central region 55 and the cross-sectional area of the yz cross section of the electronic equipment 10 (A1 < A2). The cross-sectional area A1 of the yz cross section of the front-stage region 51 is equal to the cross-sectional area A3 of the yz cross section of the rear-stage region 53 or smaller than the cross-sectional area A3 (A1 ≤ A3).

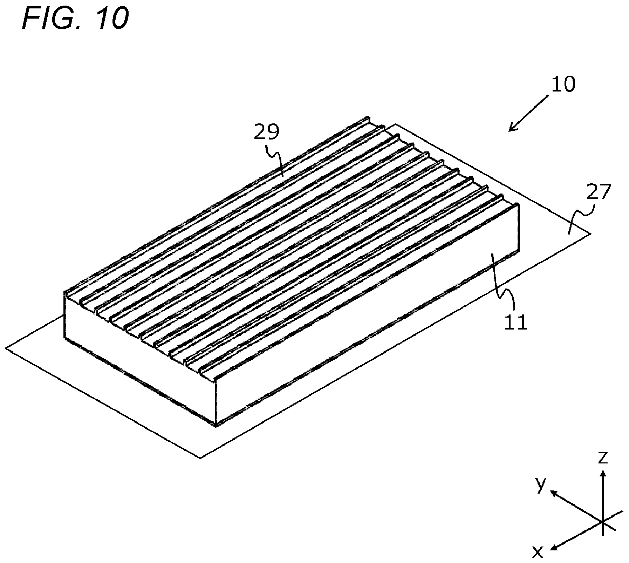

The heat releasing fin 29 has grooves extending in parallel to an air flow direction (x direction) such that flow of the air taken in from the outside through the front-stage region 51 can be facilitated (see FIG. 10). The heat releasing fin 29 is in contact with the upper surface of the antenna case 11. The heat releasing fin 29 radiates the heat transferred from a member inside the antenna case 11. The grooves of the heat releasing fin 29 are not limited to a linear shape, and may be a curved shape or a diagonal line shape such as a cross pattern in order to increase a heat releasing area.

The heat releasing fin 29 may be provided not only on the upper surface but also on the side surface. When the heat insulating material 25 is provided on the upper surface as in the first embodiment, the heat releasing fin 29 may be provided only on the side surface.

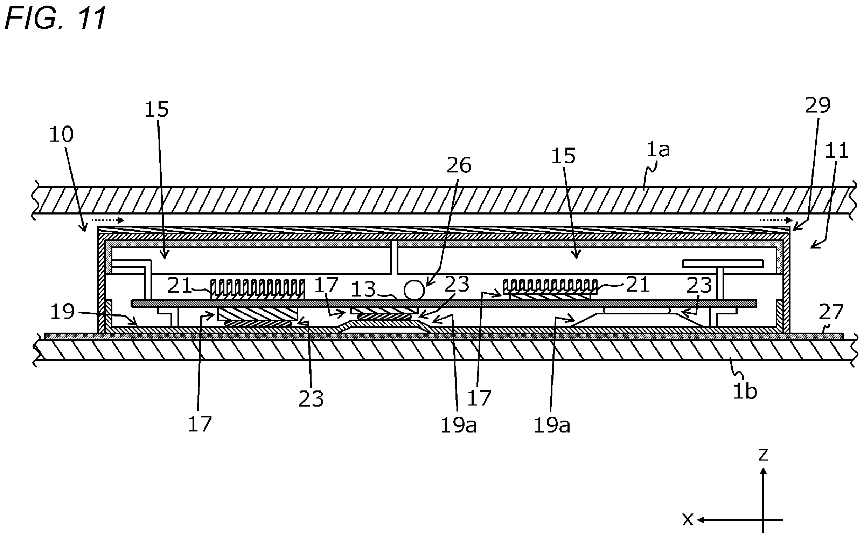

According to the third embodiment, a protrusion portion 19a protruding upward in the z direction is provided in a region of the ground plate 19 facing the mounted component 17 in the z direction (see FIG. 11). The mounted component 17 is connected to the protrusion portion 19a through the thermal interface material 23.

According to the third embodiment, when the fan 57 operates, the air in the second region 70 or the third region 80 flows into the front-stage region 51 of the first region 50 through the air supply port 51a. The air flowing into the front-stage region 51 flows into the central region 55. The air flowing into the central region 55 flows into a space between the central region 55 and the electronic equipment 10. Specifically, the air flows into a space between an inner wall of an upper surface of the central region 55 and the upper surface of the electronic equipment 10, and into a space between an inner wall of a side surface of the central region 55 and the side surface of the electronic equipment 10. The air flowing into the space between the central region 55 and the electronic equipment 10 exchanges heat with the heat releasing fin 29 and cools the heat releasing fin 29. The air after the heat exchange passes through the rear-stage region 53. The air is discharged, through the air discharge port 53a, to the third region 80, or the region different from the space including the driver seat inside the vehicle 1, such as a trunk room.

### (Effect of Temperature Adjustment from Upper Surface of Electronic Equipment 10 or the like)

The electronic equipment 10 can be cooled by flowing the air taken in from the outside through the front-stage region 51 to a periphery (the upper surface and the side surface) of the electronic equipment 10. According to the third embodiment, the air supply opening 11a and the air discharge opening 11b are not provided in the antenna case 11. Therefore, the temperature adjustment of the electronic equipment 10 can be performed by using the air taken in from the outside while suppressing impurities such as dust from entering the inside of the electronic equipment 10. A member (mounted component 17) that generates heat in the inside of the electronic equipment 10 is connected to the protrusion portion 19a. Therefore, the heat of the heat generating member is transferred to the ground plate 19 including the thermal interface material 23 and the protrusion portion 19a. Therefore, the ground plate 19 can function as a heat releasing plate.

### (Temperature Adjustment from Lower Portion of Electronic Equipment 10)

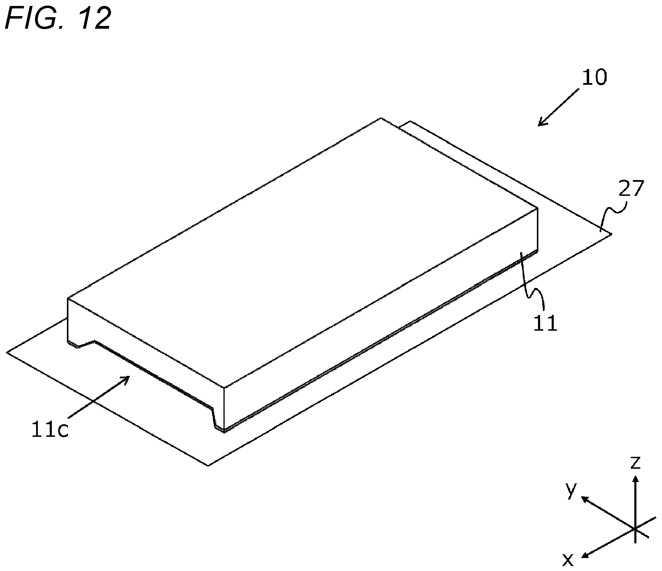

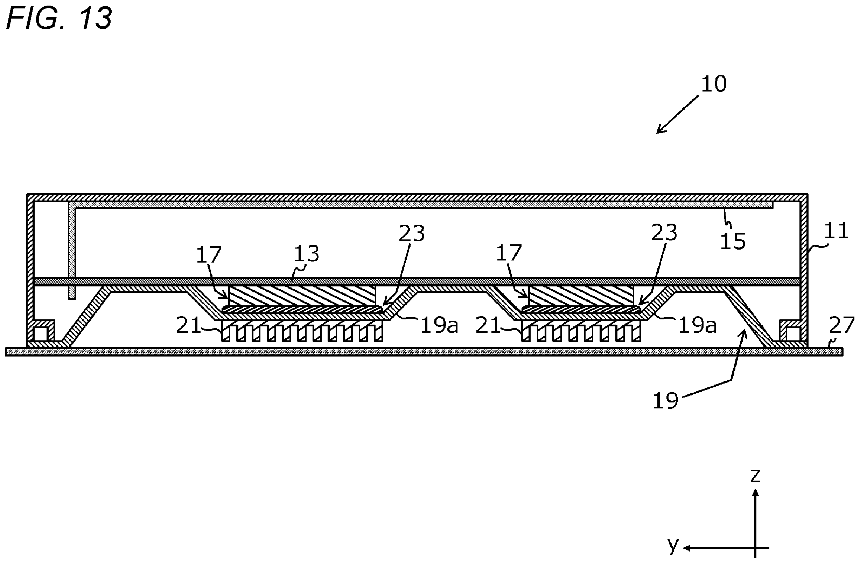

According to the third embodiment, an example has been described in which the air taken in from the outside through the front-stage region 51 passes through above the electronic equipment 10 or the like and cools the electronic equipment 10. However, the air taken in from the outside through the front-stage region 51 may pass through the lower portion of the electronic equipment 10 and cool the electronic equipment 10 (see FIGS. 12 and 13, the fourth embodiment).

According to the fourth embodiment, notches 11c are provided in lower portions of a surface of the antenna case 11 facing the first end region 55a and a surface of the antenna case 11 facing the second end region 55b such that air can pass through below the electronic equipment 10 (see FIG. 12). An opening into which the air flows is formed between the notches 11c and the bracket 27. That is, the air from the front-stage region 51 is to pass through the lower portion of the electronic equipment 10.

The ground plate 19 is configured to be close to the substrate 13 such that air can pass through a lower portion of the ground plate 19 (see FIG. 13). Specifically, both ends of the ground plate 19 in the y direction are connected to lower ends of the antenna case 11. Regions different from both ends of the ground plate 19 in the y direction has a shape protruding upward so as to be in contact with the substrate 13. However, the protrusion portion 19a protruding downward in the z direction is formed in a region different from both ends of the ground plate 19 in the y direction and where the mounted component 17 is provided below the substrate 13. An upper surface of the protrusion portion 19a is connected to the mounted component 17 through the thermal interface material 23. The heat absorbing and releasing member 21 is provided on a lower surface of the protrusion portion 19a. In order to facilitate air convection in a space between the substrate 13 and the inner wall of the antenna case 11, it is desirable that the substrate 13 be provided at a low position and the mounted component 17 be provided below the substrate 13.

According to the fourth embodiment, when the fan 57 operates, the air in the second region 70 or the third region 80 flows into the front-stage region 51 of the first region 50 through the air supply port 51a. The air flowing into the front-stage region 51 flows into the central region 55. The air flowing into the central region 55 flows into a space between the bracket 27 and the notch 11c on a side facing the first end region 55a of the electronic equipment 10. The air flowing into the space between the notch 11c of the electronic equipment 10 and the bracket 27 exchanges heat with the ground plate 19 and the heat absorbing and releasing member 21 attached to the lower surface of the protrusion portion 19a of the ground plate 19, cools the heat absorbing and releasing member 21 and the like, and is discharged from the notch 11c on the side facing the second end region 55b of the electronic equipment 10. The air after the heat exchange discharged from the notch 11c on the side facing the second end region 55b of the electronic equipment 10 passes through the rear-stage region 53. The air is discharged, through the air discharge port 53a, to the third region 80, or the region different from the space including the driver seat inside the vehicle 1, such as a trunk room.

### (Effect of Temperature Adjustment from Lower Surface of Electronic Equipment 10 or the like)

The electronic equipment 10 can be cooled by flowing the air taken in from the outside through the front-stage region 51 to the periphery (lower surface) of the electronic equipment 10. According to the fourth embodiment, the air supply opening 11a and the air discharge opening 11b are not provided in the antenna case 11. Therefore, the temperature adjustment of the electronic equipment 10 can be performed by using the air taken in from the outside while suppressing impurities such as dust from entering the inside of the electronic equipment 10. The member (mounted component 17) that generates heat in the inside of the electronic equipment 10 is connected to the protrusion portion 19a. Therefore, the heat of the heat generating member is transferred to the heat absorbing and releasing member 21 through the thermal interface material 23 and the ground plate 19 including the protrusion portion 19a. The heat absorbing and releasing member 21 is located on a flow path of the air under the ground plate 19. Therefore, the temperature adjustment of the members in the inside of the electronic equipment 10 can be performed by applying air from a different region to the ground plate 19 and the heat absorbing and releasing member 21.

### (Application Example of Shape of First End Region 55a and the Like)

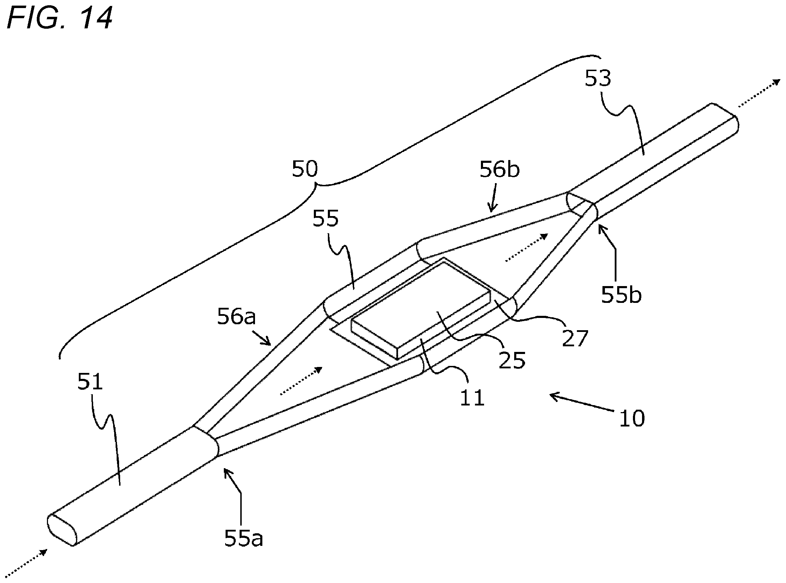

According to the third embodiment and the like, an example has been described in which the front-stage region 51 has a substantially cylindrical shape, the central region 55 has a substantially rectangular parallelepiped shape, and the flow path cross section (yz cross section) rapidly expands at a boundary (first end region 55a) on an upstream side between the front-stage region 51 and the central region 55. In addition, according to the first embodiment and the like, an example has been described in which the central region 55 has a substantially rectangular parallelepiped shape, the rear-stage region 53 has a substantially cylindrical shape, and the flow path cross section (yz cross section) rapidly narrows at a boundary (second end region 55b) between a downstream side of the central region 55 and the rear-stage region 53. However, a region including the first end region 55a may be provided with an inclined shape portion (first inclined shape portion 56a) in which the cross-sectional area gradually increases from a side where the front-stage region 51 is present (see FIG. 14, the fifth embodiment). In addition, a region including the second end region 55b may be provided with an inclined shape portion (second inclined shape portion 56b) in which the cross-sectional area gradually increases from a side where the rear-stage region 53 is present.

### (Effect of Forming End Portion of Central Region 55 into Inclined Shape)

By providing the inclined shape portions in the region including the first end region 55a and the region including the second end region 55b, it is possible to achieve a state where stagnation is less likely to occur in a flow path from the front-stage region 51 to the rear-stage region 53 through the central region 55.

### (Application Example of Housing Shape of Electronic Equipment 10)

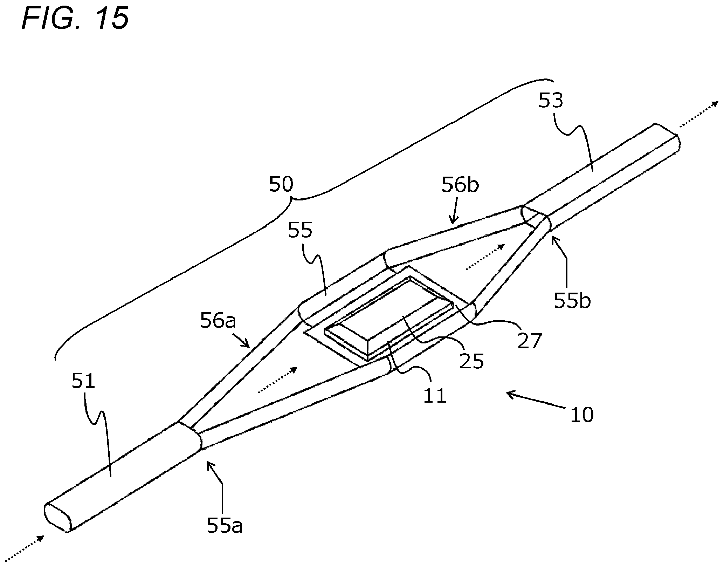

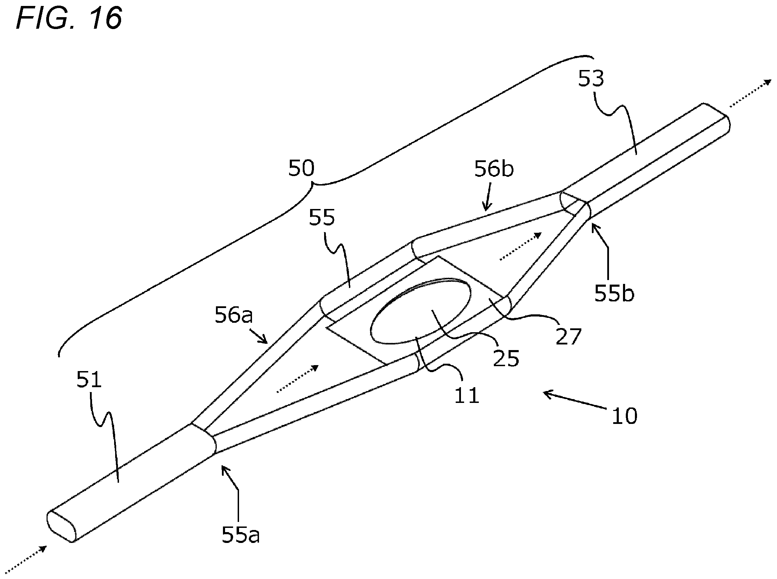

According to the third embodiment and the like, an example has been described in which an outer shape of the housing (antenna case 11) of the electronic equipment 10 is a substantially rectangular parallelepiped shape. However, the outer shape of the housing of the electronic equipment 10 is not limited to the substantially rectangular parallelepiped shape. For example, the outer shape of the housing of the electronic equipment 10 may have an inclined shape in which a dimension in the z direction gradually increases from the end portion on a side facing the first end region 55a and a dimension in the z direction gradually decreases toward the end portion on a side facing the second end region 55b. Specifically, as the outer shape of the housing of the electronic equipment 10 having the inclined shape, a housing having an upper portion of a frustum shape (see FIG. 15, the sixth embodiment), a housing having an ellipsoidal shape (see FIG. 16, the seventh embodiment), and the like can be considered.

### (Effect of Providing Inclination in Outer Shape of Housing of Electronic Equipment 10)

By providing the inclined shape in the outer shape of the housing of the electronic equipment 10, it is possible to achieve a state where stagnation is less likely to occur in a flow path from the front-stage region 51 to the rear-stage region 53 through the central region 55.

### (Application Example of First Region 50 Extending in Front-Rear Direction, Application Example of Configuration of First Region 50)

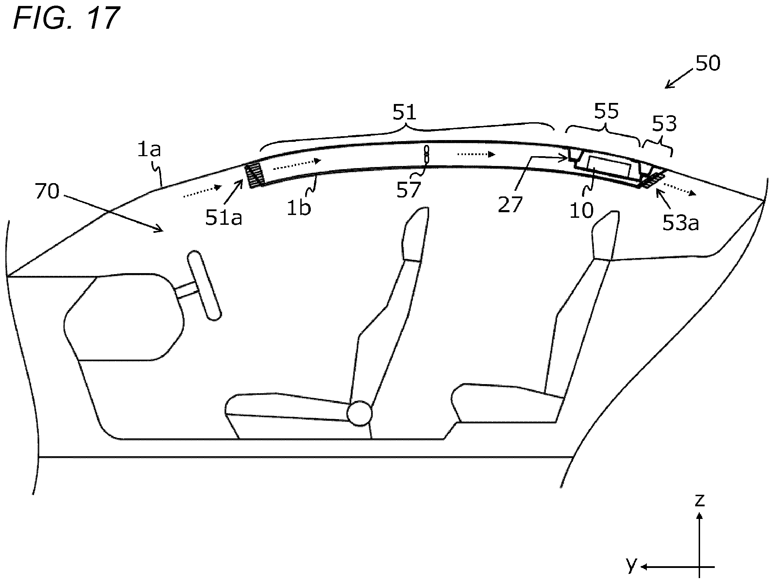

According to the first embodiment and the like, an example has been described in which the front-stage region 51, the central region 55, and the rear-stage region 53 are arranged in the left-right direction (x direction). In addition, according to the first embodiment and the like, an example has been described in which the first region 50 configured separately from these members is provided in a specific region (a region between the roof 1a and the roof lining 1b) of the vehicle 1. However, the front-stage region 51, the central region 55, and the rear-stage region 53 may be arranged in another direction (see FIG. 17, the eighth embodiment). The first region 50 may be configured integrally with the specific region of the vehicle 1. FIG. 17 illustrates an example in which the front-stage region 51, the central region 55, and the rear-stage region 53 are arranged in the front-rear direction (y direction), and an entire region between the roof 1a and the roof lining 1b constitutes the first region 50.

### (Application Example of Air being Received from Air Conditioner 1d or the like)

According to the first embodiment, an example has been described in which air from the region (second region 70) different from the first region 50 inside the vehicle 1 flows into the region where the electronic equipment 10 is present through the front-stage region 51. According to the second embodiment, an example has been described in which air from the region (third region 80) lower than the first region 50 outside the vehicle 1 flows into the region where the electronic equipment 10 is present through the front-stage region 51. In addition, according to the first embodiment and the like, an example has been described in which the first region 50 includes the front-stage region 51, the rear-stage region 53, and the central region 55. However, air from a duct 1c through which cold air of an air conditioner 1d of the vehicle 1 flows may be caused to flow into the region where the electronic equipment 10 is present through the front-stage region 51 (see FIG. 18, the ninth embodiment). In addition, the first region 50 may include only the front-stage region 51 with the rear-stage region 53 and the central region 55 omitted. In addition, the front-stage region 51 may be omitted, and the air from the air supply port 51a may directly flow into the region where the electronic equipment 10 is present.

According to the ninth embodiment, an example is illustrated in which the front-stage region 51 is connected to the duct 1c extending from the air conditioner 1d provided in a rear portion of the vehicle 1 to the space including the driver seat below the roof lining 1b through the rear pillar and the space between the roof 1a and the roof lining 1b. However, the front-stage region 51 may be connected to the duct 1c extending from the air conditioner 1d provided in a front portion (for example, an engine room) of the vehicle 1 to the space including the driver seat below the roof lining 1b through a front pillar and the space between the roof 1a and the roof lining 1b.

According to the ninth embodiment, the front-stage region 51 is connected to the duct 1c through the air supply port 51a. It is desirable that a valve 5 1b for controlling a flow of air from the duct 1c be provided in the front-stage region 51. When the air from the duct 1c is caused to flow to the front-stage region 51, the valve 51b is opened. When the air from the duct 1c is caused not to flow to the front-stage region 51, the valve 51b is closed. Opening and closing control of the valve 51b is performed by the electronic control unit (ECU, not illustrated) or the like of the vehicle 1. FIG. 18 illustrates an example in which the valve 51b is provided in a region of the front-stage region 51 close to the electronic equipment 10, but the valve 51b may be provided in a vicinity of the air supply port 51a.

The electronic equipment 10 is disposed at a position facing the other end portion of the front-stage region 51 (a portion of the front-stage region 51 from which the air is discharged), that is, at a position to which the cold air from the air conditioner 1d or the like passed through the front stage region 51 is blown. The electronic equipment 10 is attached to the vehicle 1 such as the roof lining 1b without through the first region 50.

When the accessory switch of the vehicle 1 is turned on, for example, when the engine of the vehicle 1 is turned on, the valve 51b is opened such that the air from the air conditioner 1d or the like passes through the front-stage region 51 for the first time T1. Since the valve 51b is opened, the air from the air conditioner 1d or the like flows into the front-stage region 51 of the first region 50 through the air supply port 51a. The air flowing into the front-stage region 51 is blown to the electronic equipment 10 from the other end portion of the front-stage region 51.

### (Effect of Connection to Duct 1c of Air Conditioner 1d or the like)

The air from the air conditioner 1d is caused to flow into the front-stage region 51 of the first region 50, and the temperature of the electronic equipment 10 can be adjusted at an early stage. Since a flow of the air from the air conditioner 1d or the like is utilized, it is possible to cause the air to flow into the front-stage region 51 of the first region 50 without providing the fan 57.

A configuration in which the rear-stage region 53 and the central region 55 are omitted and the air is blown from the front-stage region 51 to the electronic equipment 10 may be applied to the first embodiment (air intake from the second region 70) and the second embodiment (air intake from the third region 80).

### (Application Example of Shape of Heat Releasing Fin 39)

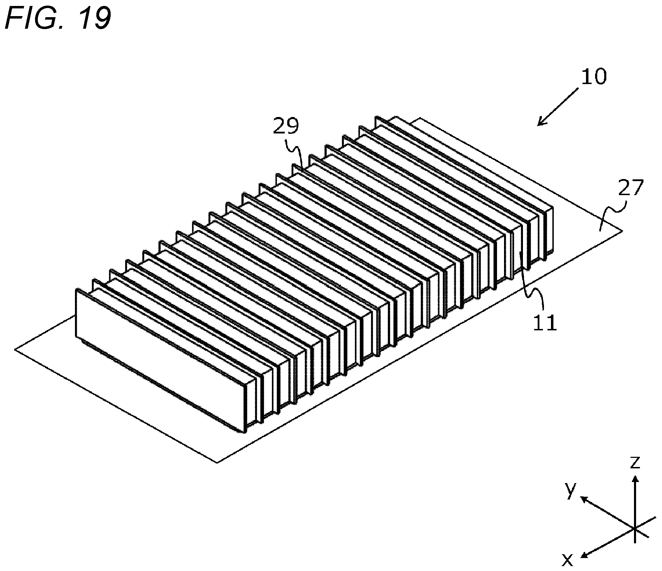

According to the second embodiment, an example has been described in which the electronic equipment 10 includes the heat releasing fin 29 provided with grooves along the flow of air. However, a direction of the grooves of the heat releasing fin 29 is not limited to the above. For example, the heat releasing fin 29 has grooves extending in a direction (the y direction and the z direction) perpendicular to a direction (x direction) in which the air flows (see FIG. 19, the tenth embodiment).

### (Application Example of Temperature Adjustment of Electronic Equipment 10)

According to the first embodiment and the like, an example has been described in which cold air flowing into the air supply port 51a flows toward the region where the electronic equipment 10 is present through the front-stage region 51, thereby cooling the electronic equipment 10. By cooling the electronic equipment 10, it is possible to suppress the members such as a semiconductor inside the electronic equipment 10 from having a high temperature, and to reduce a possibility that the performance of the electronic equipment 10 is deteriorated.

However, warm air flowing into the air supply port 51a may flow into the region where the electronic equipment 10 is present through the front-stage region 51, thereby warming the electronic equipment 10.

When the mode of warming the electronic equipment 10 is applied to the first embodiment, the second region 70 corresponds to a region that is different from the first region 50 and has warmer air than the first region 50. From the second region 70, the warmer air flows into the region of the first region 50 where the electronic equipment 10 is present through the front-stage region 51. When the mode of warming the electronic equipment 10 is applied to the second embodiment, the third region 80 corresponds to the region that is different from the first region 50 and has warmer air than the first region 50. From the third region 80, the warmer air flows into the region of the first region 50 where the electronic equipment 10 is present through the front-stage region 51. In addition, when the mode of warming the electronic equipment 10 is applied to the ninth embodiment, the air conditioner 1d causes the warmer air to flow through the duct 1c. Some or all of the warmer air flowing through the duct 1c flows into the region of the first region 50 where the electronic equipment 10 is present through the front-stage region 51. When the warmer air is caused to flow into the region where the electronic equipment 10 is present, the heat absorbing and releasing member 21 is used to absorb heat, that is, to transmit heat of the warmer air to the members of the electronic equipment 10.

By warming the electronic equipment 10, it is possible to suppress dew condensation or the like that occurs in the inside of the electronic equipment 10 due to a temperature difference from the outside in a cold environment, and to reduce the possibility that the performance of the electronic equipment 10 is deteriorated.

In addition, the present embodiment describes that the air is caused to flow into the electronic equipment 10 through the front-stage region 51, but the front-stage region 51 may be omitted, and the air in the second region 70 or the like may be caused to directly flow into the intake opening 11a of the electronic equipment 10. Accordingly, effective air required for the temperature adjustment is allowed to flow into the inside of the electronic equipment 10.

Some embodiments of the present invention have been described, but these embodiments have been presented as example, and are not intended to limit the scope of the invention. These embodiments can be implemented in various other forms, and various omissions, replacements, and modifications can be made without departing from the gist of the invention. These embodiments and modifications thereof are included in the scope of the invention and the gist of the invention, and are included in a scope of the invention described in the claims and equivalent thereto.

According to the present specification, the following aspects are provided.

### (Aspect 1)

A temperature adjusting structure for an electronic equipment provided inside a vehicle includes a first region. The first region is connected, through an air supply port, to at least one of a different region from the first region that is to have cooler air or warmer air than the first region 50, and a duct of an air conditioner of the vehicle. Air which is to flow into the air supply port is to flow into a region where the electronic equipment is present in the first region.

According to Aspect 1, air is taken from a second region or the like into the first region, and the taken air is used for temperature adjustment of an electronic equipment 10. Accordingly, the temperature adjustment of the electronic equipment is facilitated than in a mode in which the temperature adjustment is not performed using air from the outside. In addition, by continuously feeding air to the region where the electronic equipment is present, the air continues to flow to the electronic equipment. Therefore, it is easy to maintain a dried state of members of the electronic equipment.

### (Aspect 2)

The first region has a front-stage region including the air supply port. The air which is to flow into the air supply port is to flow into the region where the electronic equipment is present through the front-stage region.

### (Aspect 3)

Preferably, a fan is provided separately from the electronic equipment, the fan configured to perform at least one of causing air to flow into the region where the electronic equipment is present and causing air to be discharged from the region where the electronic equipment is present.

According to Aspect 3, by using the fan, it is possible to cause the air to flow into the region where the electronic equipment is present, regardless of a pressure state of the first region.

### (Aspect 4)

More preferably, the fan is configured to be operated when an accessory switch of the vehicle is turned on.

According to Aspect 4, immediately before the accessory switch of the vehicle is turned on, there is a possibility that a temperature of the electronic equipment is high or low, such as the vehicle is not running. Therefore, if the fan is operated when the accessory switch of the vehicle is turned on, the temperature of the electronic equipment can be adjusted more effectively than in a mode in which the fan is operated in another time zone.

### (Aspect 5)

Preferably, a housing of the electronic equipment has an air supply opening and an air discharge opening. Air which is to flow into the region where the electronic equipment is present is to flow into an inside of the housing through the air supply opening, and to be discharged to an outside of the housing through the air discharge opening.

According to Aspect 5, by providing air holes (the air supply opening and the air discharge opening) in the housing of the electronic equipment, the air can be taken into the inside of the electronic equipment. Therefore, the temperature adjustment of the members in the inside of the electronic equipment is facilitated than in a mode in which the temperature is adjusted by applying the air to the outside of the electronic equipment.

### (Aspect 6)

More preferably, the electronic equipment is provided with a shielding plate that covers a mounted component attached to a substrate, and a heat absorbing and releasing member. The shielding plate and the heat absorbing and releasing member are configured integrally.

According to Aspect 6, configurations of the heat absorbing and releasing member and the shielding plate can be simplified, and heat transfer efficiency can be increased.

### (Aspect 7)

Preferably, the first region includes a central region that accommodates the electronic equipment. A first end region on an upstream side of the central region has a shape in which a cross-sectional area gradually increases from the upstream side.

According to Aspect 7, by providing an inclined shape portion in a region including the first end region, it is possible to achieve a state where stagnation is less likely to occur in a flow path.

### (Aspect 8)

Preferably, the first region is connected to the different region through the air supply port. The different region is a space including the driver seat, or an underfloor of the vehicle.

According to Aspect 8, the different region is located at a position lower than the first region, and may be in a temperature state different from that of the first region. Therefore, the temperature adjustment of the electronic equipment can be performed by the air flowing from the second region.

### (Aspect 9)

Preferably, the front-stage region is connected to the duct through the air supply port. The electronic equipment is provided at a position facing a portion of the front-stage region from which the air is to be discharged. A valve configured to control a flow of the air from the duct to the front-stage region is provided.

According to Aspect 9, it is possible to cause cold air or warm air from the air conditioner to flow into the first region, and to adjust the temperature of the electronic equipment at an early stage.

### (Aspect 10)

Preferably, air from the air supply port is to pass through a lower portion of the electronic equipment. A heat absorbing and releasing member is provided in a region of the lower portion of the electronic equipment through which the air from the air supply port is to pass.

According to Aspect 10, it is possible to adjust the temperature of the electronic equipment by causing air taken in from the outside to flow to a periphery (lower surface) of the electronic equipment. The temperature adjustment of the electronic equipment can be performed by using the air taken in from the outside while suppressing impurities such as dust from entering the inside of the electronic equipment. By cooling or warming the heat absorbing and releasing member, the temperature adjustment of the members in the inside of the electronic equipment can be performed.

### REFERENCE SIGNS LIST

1: vehicle
1a: roof
1b: roof lining
1c: duct through which cold air or warm air of air conditioner flows
1d: air conditioner
10: electronic equipment (antenna device)
11: antenna case (housing)
11a: air supply opening
11b: air discharge opening
11c: notch
13: substrate
15: antenna element
17: mounted component
19: ground plate
19a: protrusion portion
21: heat absorbing and releasing member
23: thermal interface material
24: shielding plate
25: heat insulating material
26: heat storage material
27: bracket
29: heat releasing fin
50: first region (cooling air introduction region)
51: front-stage region
51a: air supply port
51b: valve
53: rear-stage region
53a: air discharge port
55: central region
55a: first end region
55b: second end region
56a: first inclined shape portion
56b: second inclined shape portion
57: fan
70: second region (space including driver seat)
80: third region (underfloor region)
A1: cross-sectional area of yz cross section (flow path cross section) of front-stage region
A2: difference between cross-sectional area of yz cross section (flow path cross section) of central region and cross-sectional area of yz cross section of electronic equipment 10
A3: cross-sectional area of yz cross section (flow path cross section) of rear-stage region
A4: opening area of intake opening and air discharge opening
H: humidity of electronic equipment
Hth: humidity threshold
T: temperature of electronic equipment
T1: first time (time during which fan is operated)
Tth: temperature threshold

## Claims

1. A temperature adjusting structure for an electronic equipment provided inside a vehicle, the temperature adjusting structure comprising a first region,
wherein the first region is connected, through an air supply port, to at least one of a different region from the first region that is to have cooler air or warmer air than the first region, and a duct of an air conditioner of the vehicle, and
air which is to flow into the air supply port is to flow into a region where the electronic equipment is present in the first region.

2. The temperature adjusting structure according to claim 1,
wherein the first region has a front-stage region including the air supply port, and
the air which is to flow into the air supply port is to flow into the region where the electronic equipment is present through the front-stage region.

3. The temperature adjusting structure according to claim 1 or 2,
wherein a fan is provided separately from the electronic equipment, the fan configured to perform at least one of causing air to flow into the region where the electronic equipment is present and causing air to be discharged from the region where the electronic equipment is present.

4. The temperature adjusting structure according to claim 3,
wherein the fan is configured to be operated when an accessory switch of the vehicle is turned on.

5. The temperature adjusting structure according to any one of claims 1 to 4,
wherein a housing of the electronic equipment has an air supply opening and an air discharge opening, and
air which is to flow into the region where the electronic equipment is present is to flow into an inside of the housing through the air supply opening, and to be discharged to an outside of the housing through the air discharge opening.

6. The temperature adjusting structure according to claim 5,
wherein the electronic equipment is provided with a shielding plate that covers a mounted component attached to a substrate, and a heat absorbing and releasing member, and
the shielding plate and the heat absorbing and releasing member are configured integrally.

7. The temperature adjusting structure according to any one of claims 1 to 6,
wherein the first region includes a central region that accommodates the electronic equipment, and
a first end region on an upstream side of the central region has a shape in which a cross-sectional area gradually increases from the upstream side.

8. The temperature adjusting structure according to any one of claims 1 to 7,
wherein the first region is connected to the different region through the air supply port, and
the different region is a space including a driver seat, or an underfloor of the vehicle.

9. The temperature adjusting structure according to claim 2,
wherein the front-stage region is connected to the duct through the air supply port,
the electronic equipment is provided at a position facing a portion of the front-stage region from which the air is to be discharged, and
a valve configured to control a flow of the air from the duct to the front-stage region is provided.

10. The temperature adjusting structure according to any one of claims 1 to 9,
wherein air from the air supply port is to pass through a lower portion of the electronic equipment, and
a heat absorbing and releasing member is provided in a region of the lower portion of the electronic equipment through which the air from the air supply port is to pass.
